# EUROPÄISCHE PATENTSCHRIFT

(11) **EP 0 508 946 B1**
(45) Veröffentlichungstag und Bekanntmachung des Hinweises auf die Patenterteilung: **24.07.1996**
(21) Anmeldenummer: 92810184.9
(22) Anmeldetag: 12.03.1992
(51) Int. Cl.: B32B 15/08, H05K 3/38

(54) **Metallfolie mit einer strukturierten Oberfläche**
Metal foil with structural surface
Feuille métallique à surface structurée

(30) Priorität: 10.04.1991 CH 1063/91
(43) Veröffentlichungstag der Anmeldung: 14.10.1992
(73) Patentinhaber: Dyconex AG, CH-8052 Zürich (CH)
(72) Erfinder: Schmidt, Walter, Dr., CH-8050 Zürich (CH); Martinelli, Marco, CH-8413 Neftenbach (CH)
(74) Vertreter: Frei, Alexandra Sarah

(56) Entgegenhaltungen:
- EP-A- 0 016 952
- US-A- 4 086 114
- US-A- 4 446 188

## Beschreibung

Die Erfindung liegt auf dem Gebiet der Verbindungsträger für elektronische Bauelemente und betrifft ein Verfahren zur Herstellung einer laminierten Verbindung zwischen einer Metalloberfläche und einer Polymeroberfläche in Verbindung mit einem Verfahren zur Herstellung einer mehrlagigen, laminierten Leiterplatte sowie die nach dem Verfahren hergestellte Leiterplatte und eine Metallfolie als Zwischenprodukt.

Leiterplatten für das Realisieren elektronischer Schaltungen tragen und verbinden elektronische Bauelemente. Dabei wird Kompaktheit und hohe verbindungsdichte angestrebt. Es gehört daher zum Stand der Technik, integrierte Schaltungen in Form von oberflächenmontierbaren Bauelementen, sogenannten "surface mounted devices", gängig abgekürzt mit SMD, oder sogenannten "leadless chip carriers", abgekürzt mit LCC, direkt auf die oberflachliche Verbindungslage der Leiterplatten aufzulöten. Die Leiterplatten selber sind dabei meist mehrlagig ausgeführt, das heisst, sie weisen mehrere Schichten von Leiterbahnenlagen auf.

Die Zuverlässigkeit von auf einer Leiterplatte aufgelöteten SMD wird stark beeinträchtigt, falls der thermische Ausdehnungskoeffizient der Bauelemente sich von jenem der Leiterplatte merklich unterscheidet. Unterschiedliche Wärmedehnungen von Platte und Komponenten führt zu hohen Scherspannungen an den Lötstellen, was in der Folge zu Rissen in letzteren führen kann. Dieses Problem ist bei der Verwendung von Bauelementen mit Anschlussbeinchen nicht in diesem Mass vorhanden, da die Beinchen als flexible Zwischenglieder zwischen Platte und Bauteil dienen und die Spannungen so ausgeglichen werden können.

Herkömmliche Leiterplatten weisen je nach verwendeten Materialien einen thermischen Ausdehnungskoeffizienten von 15 bis 20 ppm/°C auf, Bauelemente in Keramikgehäusen ohne Anschlussdrähte ("leadless ceramic chip carriers", LCCC) einen solchen von ca. 6 ppm/°C. Der Einsatz von LCCC bedingt daher Leiterplatten, deren Wärmedehnung durch geeignete Massnahmen reduziert sind, damit die Spannungen auf ein tolerierbares Mass beschränkt bleiben.

Gebräuchliche Massnahmen zur Reduzierung der Wärmedehnung von Leiterplatten sind der Einbau von Kernen oder Zwischenlagen aus temperaturstabilen Materialien. Bekannt sind z.B. Bleche bzw. Folien aus einem Verbund von Kupfer und Invar (einer Legierung aus Nickel und Eisen mit sehr niedrigem Ausdehnungskoeffizient), aus Molybdän (mit einem thermischen Ausdehnungskoeffizient von ca. 5 ppm/°C) oder Kerne mit Kohlefaserverstärkung. Weitere Hinweise zu dieser Problematik vermittelt die EPA-A-0393312 derselben Anmelderin.

Mit diesen Massnahmen wird erreicht, dass der Gesamtverbund von temperaturstabiler Verstärkung und Leiterbahnenlagen, also die Leiterplatte, einen angepassten, niedrigen Ausdehnungsfaktor bekommt und so die thermischen Spannungen an den Lötstellen reduziert werden. Jedoch ergibt sich dadurch ein neues Problem. Bei Temperaturänderungen wirken an der Grenzfläche zwischen den Kernen oder Zwischenlagen aus den temperaturstabileren Materialien und den übrigen Schichten der Leiterplatte Scherspannungen, da die Kerne bzw. die Zwischenlagen, bedingt durch ihre hohe mechanische Festigkeit, die Leiterplatte dazu zwingen, dimensionsstabil zu bleiben, wobei die übrigen Schichten der Platte, die die Tendenz haben, sich mit der Temperaturänderung mehr zu dehnen bzw. zusammenzuziehen, über die Klebverbindung in ihrer Bewegungsfreiheit eingeschränkt werden. Werden unbehandelte Zwischenlagen mit Leiterbahnenlagen zu einer Leiterplatte zusammenlaminiert, so muss bei deren Verwendung, bedingt durch die normalen Temperaturspiele, mit einer Delamination gerechnet werden, das heisst, der Verbund zwischen Leiterbahnenlage und Zwischenlage löst sich. Diese Trennung ist besonders dann zu beobachten, wenn als Basismaterial für das Laminat glasfaserverstärktes Polyimid-Harz verwendet wird. Aber auch Basismaterialien aus Cyanat-Ester-Harzen zeigen schlechte Ergebnisse.

Auch zur Ueberwindung dieses Problems sind Lösungen bekannt. Die Oberflächen der Metallfolien (Kupfer/Invar, Kupfer/Molybdän) werden vorbehandelt, durch Schwarzoxydieren, Sandstrahlen oder Aufbringen einer "treatment"-Schicht. Das normalerweise verwendete Schwarzoxydieren reicht zwar aus, um das Delaminieren glasfaserverstärkter Epoxydmaterialien zu verhindern, genügt jedoch nicht bei Basismaterialien aus Polyimid- oder Cyanat-Ester-Harzen. Auch Sandstrahlen vermag nicht die erforderlichen Haftwerte zu erbringen. "Treating" ist ein Verfahren, mit welchem eine zusätzliche Schicht, üblicherweise aus Kupfer, auf die stabilisierende Zwischenlage galvanisch so abgeschieden wird, dass eine rauhe Oberfläche entsteht. Das Verfahren ist aufwendig und teuer. Es wird immer auf die ganze Oberfläche angewendet, so dass keine erwünschten oder gar nötigen Aussparungen möglich sind. Zudem haftet dem Produkt daraus der Nachteil an, empfindlich zu sein bezüglich Druck und Verkratzen, und einer späteren photochemischen Bearbeitung nicht mehr zugänglich zu sein.

Weitere Verfahren zur Haftverbesserung zwischen zusammenlaminierten Schichten bei Temperaturschwankungen, die sich alle mit einer Aufrauhung der einen Oberfläche befassen, sind beispielsweise auch bekannt aus der europäischen Anmeldeschrift EP-A-0016952 (Aufrauhung durch Aufbringen einer dendritischen Schicht), aus der US-A-4086114 (Aufrauhung durch mechanische Bearbeitung) und aus US-A-3177103 (Aufrauhen durch Anätzen). Sie alle sind mit den einen oder anderen der oben erwähnten Nachteile behaftet.

Der Erfindung liegt die Aufgabe zu Grunde, eine verbesserte Massnahme zu finden, um das Delaminieren der Schichten unterschiedlicher Wärmedehnung in einer laminierten, mehrlagigen Leiterplatte zu verhindern, ohne die oben erwähnten Unzulänglichkeiten und Nachteile in Kauf nehmen zu müssen. Sie wird durch eine besondere Strukturierung der Oberfläche von Metallfolien und die Verwendung dieser Folien für die Leiterplatten gelöst.

Die heute verwendeten Materialien für Kerne oder Zwischenlagen weisen üblicherweise eine äusserste Schicht aus elektrisch und thermisch leitendem, galvanisierbarem Metall, insbesondere Kupfer auf. Es sind aber auch Folien nur aus Invar oder nur aus Molybdän erhältlich. Die Erfindung zielt darauf ab, die Haftung zwischen der Metallaussenfläche und der darauf anzubringenden Leiterbahnenschicht zu verbessern. Dies lässt sich auf effiziente und kostengünstige Art erreichen, indem mittels photochemischer Behandlung der Metallschicht deren Oberfläche fein strukturiert wird. Das photochemische Verfahren erlaubt, mit an sich bekannten Mitteln in wenigen und wenig aufwendigen Arbeitsgängen ein feines, nahezu beliebig wählbares Muster von speziell geformten Vertiefungen herauszuätzen oder/und Erhöhungen aufzugalvanisieren. Derart strukturiert ist die Kontaktfläche zwischen dem Metall und dem Verbindungsmaterial der auflaminierten nächsten Lage, üblicherweise ein Harz, wesentlich grösser als bei der unbehandelten Metallschicht, was die Haftkraft insgesamt erhöht. Die weitgehend frei wählbare Form der Vertiefungen und Erhöhungen erlaubt es zudem, den parallel zur Oberfläche gerichteten Scherkräften allseitig wirksam zu begegnen. Das Erzeugen von Mustern für Photomasken kann auf einfachste Weise durch Vorgabe eines Grundelements des Musters und rechnerunterstütztes Vervielfachen desselben erfolgen. Verschiedene Muster in derselben Maske sind ebenfalls leicht machbar und insbesondere können grössere Teile mit beliebiger Abgrenzung von der Musterung ausgenommen werden.

Die Erfindung hat den Vorteil, sich auf gängige Technik abzustützen; sie kann praktisch in jeder Leiterplattenfertigung angewendet werden, ohne dass dazu spezielle Einrichtungen vorhanden sein müssten. Das Verfahren ist wesentlich kostengünstiger als das "treating" von Kupferoberflächen; das Erzeugnis ist robust gegenüber Kratzern und Druckbelastungen und kann wie eine normale Kupferoberfläche behandelt und weiterverarbeitet werden. Wo mit den üblichen metall-, insbesondere kupferbeschichteten Folien gearbeitet wird, hat das Herausätzen von Vertiefungen überdies den positiven Effekt der Schwächung des lateralen Zusammenhalts der äusseren Metallschicht, wodurch die innere, thermisch stabilere Schicht ihre dimensionsstabilisierende Wirkung noch besser entfalten kann.

Nachfolgend wird die Erfindung anhand von Figuren und am Beispiel einer einzigen zu behandelnden Rupferschicht auf einer Kupfer/Invar/Kupfer-Folie detaillierter erörtert. Es versteht sich, dass dies nicht im Sinne einer Einschränkung geschieht. Das Verfahren lässt sich auf andere Folien und Metallschichten anwenden, die Strukturierung kann im gleichen Arbeitsgang beidseitig erfolgen und für ein und dieselbe Leiterplatte wird die Behandlung für die verschiedenen Schichten so oft wie nötig durchgeführt.
- Fig. 1: zeigt einen Abschnitt aus einem beispielsweisen Aufbau einer Leiterplatte im Querschnitt.
- Fig. 2: zeigt einen Ausschnitt aus einer Leiterplatte mit einer "treatment"-Schicht (Stand der Technik).
- Fig. 3: zeigt die Schritte des erfindungsgemässen Verfahrens in der Ausführungsvariante des Subtraktiv-Verfahrens.
- Fig. 4: zeigt ausschnittsweise Beispiele der Struktur der Oberfläche, hergestellt nach dem Verfahren gemäss Figur 3 in Draufsicht.
- Fig. 5: zeigt die Schritte des erfindungsgemässen Verfahrens in der Ausführungsvariante des Additiv-Verfahrens.

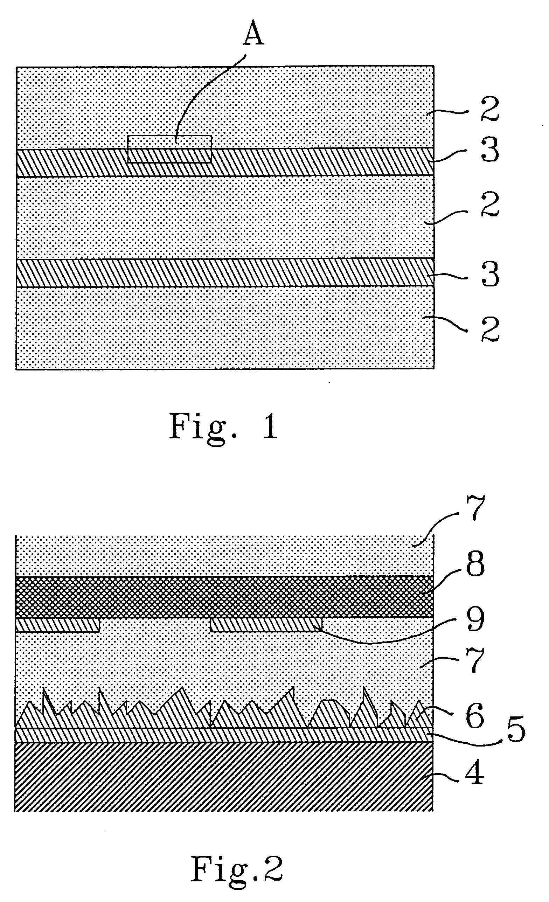

In der Figur 1 ist ein Beispiel für eine mehrlagige, laminierte Leiterplatte angegeben, deren Wärmedehnung durch den Einbau zweier Metallfolien 3 mit kleinem thermischem Ausdehnungskoeffizient - je nach Aufbau ca. 1 bis 6 ppm/°C - in Grenzen gehalten wird. Solche Folien können z.B. aus einer Molybdän- oder Invar-Schicht mit oder ohne ein- oder beidseitig aufgewalzten Kupfer- oder Kupfer-Nickel-Belägen verschiedener Dicke bestehen. Zwischen den beiden Folien 3 und an den beiden Aussenflächen ist je eine, in der Regel mehrschichtige Leiterbahnenlage 2 gezeichnet, deren thermischer Ausdehnungskoeffizient zwischen etwa 12 und 20 ppm/°C liegt. Der mittlere thermische Ausdehnungskoeffizient für die ganze Leiterplatte liegt dann um 7 bis 10 ppm/°C. An der Berührungsfläche, wo die Metallfolie 3 und die Leiterbahnenlage 2 zusammenlaminiert sind, besteht bei Temperaturänderungen die Gefahr der Delaminierung. Um dies zu verhindern, werden spezifische Massnahmen der Oberflächenbehandlung der Metallfolie getroffen. An der Stelle des Ausschnittes A in Figur 1, vergrössert dargestellt, lassen sich solche Massnahmen zeigen.

Die Figur 2 zeigt in Vergrösserung die Stelle des Ausschnitts A von Figur 1 mit einer bekannten Möglichkeit der Oberflächenbehandlung der Metallfolie zur Verbesserung der Haftung des Laminats, das "treatment". Figur 2 zeigt also den bekannten Stand der Technik. Von der Folie 3 ist hier der obere Teil dargestellt, bestehend aus der Invar-Lage 4, dem Kupferbelag 5 und der nach einem speziellen galvanischen Verfahren abgeschiedenen "treatment"-Schicht 6 mit ihrer rauhen Oberfläche. Darüber gezeigt ist der untere Teil der auflaminierten Leiterbahnenlage 2, bestehend aus dem Kleber 7, dem Kunststoffträger 8 und den elektrisch leitenden Verbindungen 9; diese Schichtfolge kann in der Leiterbahnenlage 2 wiederholt vorhanden sein.

Folien mit einer "treatment"-Schicht sind nach den bisherigen Erkenntnissen am besten geeignet, dem Delaminieren vorzubeugen, vermögen es aber nicht in allen Fällen zu verhindern. "Treating" wird allerdings nur auf Kupferschichten angewendet. Molybdän oder Invar sind zu hart für ein "treating".

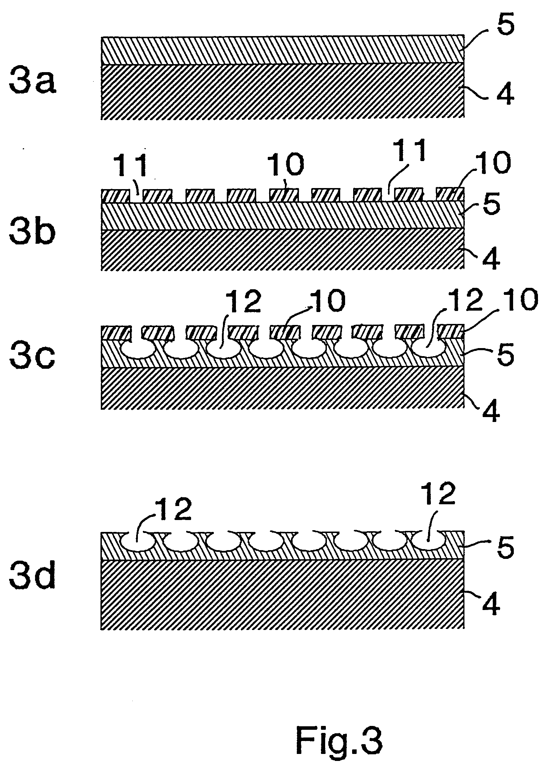

In Figur 3 ist in vier aufeinanderfolgenden Bildern der Verfahrensschritt der einen Variante zur Herstellung einer strukturierten Oberfläche in der Metallschicht einer Lage einer mehrlagigen Leiterplatte dargestellt. Figur 3a zeigt das Ausgangsmaterial, hier eine Metallfolie 3 mit einem Kernteil 4, bedeckt mit der Metallschicht 5. Derartige Folien sind im Handel erhältlich und bestehen z.B. aus einem Verbund aus Invar oder Molybdän im Kernteil 4 und aufgewalztem Kupfer als Metallschicht 5. In der Folge wird als Beispiel von einer Kupfer/Invar-Folie ausgegangen. Die Teilschritte des Verfahrensschrittes sind für die eine der beiden Kupferschichten 5 gezeigt. Das Verfahren lässt sich aber ohne weiteres im gleichen Arbeitsgang beidseitig anwenden. Alle Teilschritte einzeln betrachtet sind aus anderen Abläufen für die Herstellung von Leiterplatten an sich bekannt.

Auf der Kupferschicht 5 wird als nächstes eine Photoresistschicht 10 aufgebracht. Photoresist, meist ein Polymerisat, verändert unter Einwirkung von Licht örtlich seine Resistenz gegenüber gewissen Chemikalien, die für das Entwickeln eingesetzt werden, wodurch sich Ausnehmungen in der Photoresistschicht herstellen lassen. Photoresist ist resistent gegenüber Aetzmitteln für das Metall, das sie abdecken. Die Figur 3b zeigt die mit einer bereits belichteten und entwickelten Photoresistschicht 10 bedeckte Kupferschicht 5. Die Photoresistschicht 10 weist an den Stellen, an welchen Vertiefungen in der Metalloberfläche entstehen sollen, Ausnehmungen 11 auf. Die Form der Ausnehmungen ist frei wählbar. Die Abmessungen betragen bevorzugt ca. 50 bis 100 Mikrometer.

Im nächsten Teilschritt wird das Kupfer geätzt, aber lediglich teilweise, also nicht ganz weggeäzt. An den Stellen der Ausnehmungen 11 in der Photoresistschicht 10 entstehen so Vertiefungen 12 in der darunterliegenden Kupferschicht 5. Die Figur 3c zeigt den Zustand nach diesem Teilschritt.

Mit dem üblichen Aetzvorgang - bevorzugt wird Sprühätzung angewendet - beginnt der sukzessive Materialabtrag an der Oberfläche gleichmässig über die ganze Oeffnung im Photoresist. Mit fortschreitender Tiefe des Ausätzens weitet sich die Vertiefung leicht aus. Dieses bekannte Unterätzen hat bei den kleinen Vertiefungen, wie sie hier erzeugt werden, zur Folge, dass eine bauchige Höhle entsteht. Die Aetztiefe wird massgebend von der Durchlaufgeschwindigkeit bzw. Verweildauer des Werkstücks im Aetzprozess bestimmt; es handelt sichdabei um bekannte, gut beherrschbare Vorgänge. Bevorzugte Tiefen liegen zwischen 10 und 50 Mikrometern.

Die Unterhöhlung in der ausgeätzten Vertiefung ist für den angestrebten Zweck der Strukturierung erwünscht. Nach dem Auflaminieren einer weiteren Schicht härtet das Harz in den Höhlungen aus. Es entsteht eine formschlüssige Verbindung, die ein Trennen der Schichten nahezu verunmöglicht. Einzig die Elastizität der Materialien lässt dies bei sehr grossen Kräften durch Ueberwindung des Druckknopfeffekts noch zu.

Eine weitere Verbesserung bezüglich der Form der Vertiefung lässt sich erzielen durch vorgängiges Härten der Oberfläche der Kupferbeschichtung gegenüber dem Aetzmittel. Hiezu wird vor dem Aufbringen des Photoresists Nickel auf das Kupfer aufgebracht und durch eine Wärmebehandlung eindiffundiert. Der Aetzvorgang durch die Deckschicht verläuft dann zunächst langsam, bis die gehärtete Schicht durchgeätzt ist. Danach findet ein ausgeprägtes Unterätzen der härteren Deckschicht statt. Die überhängenden Ränder der Vertiefungen sind damit gegenüber der zuvor beschriebenen Variante dicker und stärker.

Anschliessend an das Aetzen wird der Photoresist gestrippt, das heisst in bekannter Weise wieder entfernt. Zurück bleibt die ursprüngliche Metallfolie 2 mit Ausnehmungen 12 in der Kupferschicht 5, welche die gewünschte Strukturierung der Oberfläche in Musterung und Form ausmachen.

Nach diesem Subtraktiv-Verfahren wird die Kupferschicht geschwächt, was für die elektrische Funktion entsprechend zu berücksichtigen ist, falls diese eine Rolle spielt. Vorteilhaft wirkt sich diese Schwächung bezüglich der mechanisch-thermischen Eigenschaften aus. Da weniger Kupfer mit vergleichsweise hohem thermischem Ausdehnungskoeffizienten vorhanden ist, kann das Invar seine dimensionsstabilisierende Wirkung noch besser entfalten. Zudem ist die Kupferschicht in ihrer aufgebrochenen Form weniger steif denn als gleichmässig dicke Folie.

Das Verfahren ist nicht beschränkt auf Kupferbeschichtungen. Auch unbedeckte Invar- oder Molybdänfolien lassen sich nach den geschilderten Teilschritten geeignet strukturieren.

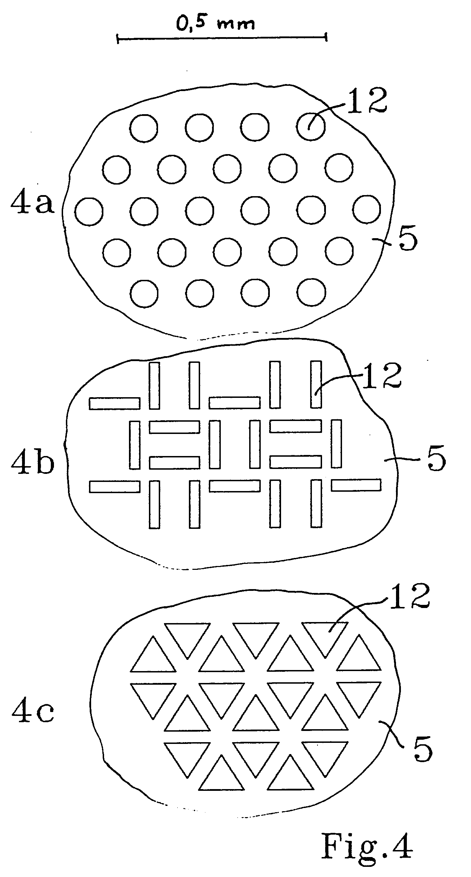

Für die Wahl der Musterung und der Form der Vertiefungen sind die Eigenschaften der verwendeten Materialien von ausschlaggebender Bedeutung. Um den Scherkräften wirksam zu begegnen, kann beispielsweise der Einbau eigentlicher Barrieren empfehlenswert sein. Die Figur 4 zeigt die Draufsicht auf eine strukturierte Oberfläche für mögliche Muster der Ausnehmungen 12 in drei Ausführungsvarianten, dies als Beispiel, nicht als einschränkender Weise.

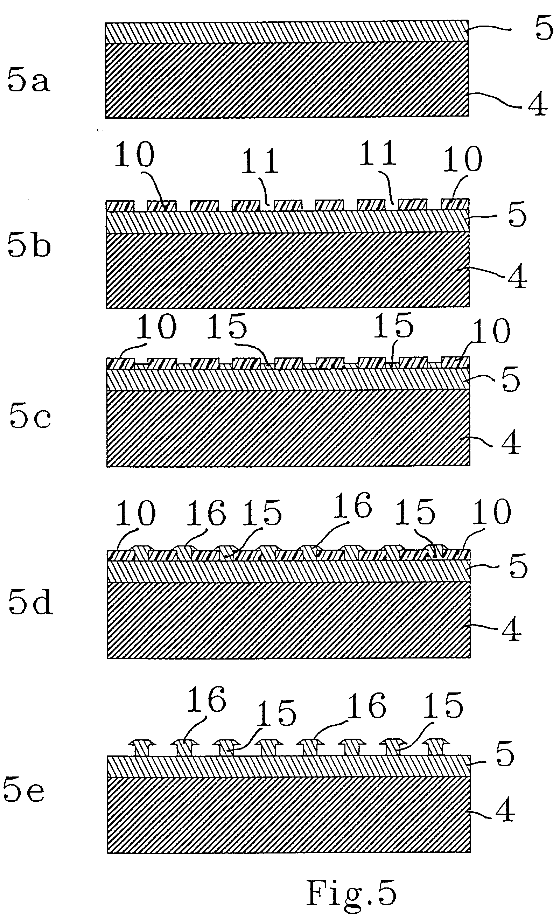

Eine andere Verfahrensvariante, das Additiv-Verfahren, sieht vor, auf der Metallschicht 5 Erhöhungen aus dem nämlichen Material aufzugalvanisieren. Die zugehörigen Teilschritte sind in der Figur 5 angegeben. Dabei wird vom selben Verfahrensstand ausgegangen wie weiter oben im Zusammenhang mit der Figur 3 beschrieben. Die Figur 5a zeigt wiederum die Kupfer/Invar-Folie, die Figur 5b den Zustand nach aufbringen, belichten und entwickeln des Photoresists 10 auf der Kupferschicht 5. Die Ausnehmungen 11 sind hier gemustert und geformt gemäss den Erhöhungen, die an diesen Stellen aufgebracht werden sollen. Im übrigen unterscheiden sich die Teilschritte bis hierher nicht von jenen des Subtraktiv-Verfahrens.

In einem nächsten Schritt wird Kupfer galvanisch aufplattiert. In den Ausnehmungen 11 entstehen Erhöhungen 15 aus Kupfer, wie dies in Figur 5c gezeigt ist. Die Dicke der aufplattierten Schicht bzw. der aufplattierten Inseln, den Erhöhungen 15, wird durch die Dauer und Stärke des Galvanisierprozesses bestimmt. Auch bei diesem Verfahren lässt sich das Muster und die Form der Erhöhungen frei wählen. Es hat den grossen Vorteil, dass überhängende Strukturen erzeugt werden können, wie dies in Figur 5d gezeigt ist. Der Galvanisierungsprozess wird gegenüber dem Zustand von Fig. 5c weiter fortgesetzt. Dabei scheidet sich Kupfer nicht nur in den Ausnehmungen 11 ab, sondern auch, ausgehend von den Erhöhungen 15, über der Photoresistschicht 10. Es entstehen Kragen 16 an den Erhöhungen 15, die damit eine pilzförmige Gestalt erhalten. Nach dem strippen des Photoresists bleiben die pilzförmigen Erhöhungen 15 mit ihren Kragen 16 zurück, wie dies in Fig. 5e gezeigt ist. Die Kragen 16 ergeben nach einem späteren Verfahrensschritt, in dem die nächste Leiterbahn auflaminiert wird, eine extrem günstige Verankerung des Harzes bzw. Klebers auf der Metalloberfläche. Die Galvanisierung kann aber auch bereits beim Zustand von Fig. 5c gestoppt und der Photoresist gestrippt werden (nicht gezeichnet). Es ergeben sich dabei ähnliche Strukturen und Formen wie mit dem Subtraktiv-Verfahren.

Im allgemeinen wird man bei der Wahl des Verfahrens auf die zusätzlichen Anforderungen abstellen. Metallfolien der beschriebenen Art können thermische, elektrische und mechanische Funktionen erfüllen. Falls ausschliesslich eine Versteifung und beschränkte Wärmedehnung angestrebt wird, genügen Folien aus Invar, Molybdän oder ähnliche; beide Verfahren lassen sich anwenden, wobei das Aufplattieren besipielsweise mit Nickel oder Kupfer erfolgen kann. Wird zusätzlich eine gute elektrische Leitfähigkeit angestrebt, beispielsweise um eine Abschirmung zu erzielen, dürfte eine Kupferbeschichtung, strukturiert nach dem Subtraktiv-Verfahren, die richtig Wahl sein. Steht hingegen die Funktion der Wärmeleitung im Vordergrund, so drängt sich eine relativ dicke Rupferschicht auf und das Additiv-Verfahren dürfte angezeigt sein.

Mit diesen photochemischen Verfahren ist es auch ohne weiteres möglich, nur Teile der Folie zu strukturieren und andere Teile, die später z.B. nicht überdeckt werden, aber als Abschirmungsanschluss ausgestaltet werden sollen, auszusparen.

Das Verfahren und das Erzeugnis daraus wurde am Beispiel der Kupfer/Invar-Folie, wie sie als Zwischenlage in Leiterplatten verwendet wird, erläutert. An dieser Folienoberfläche, die zwecks Herstellung einer mehrlagigen Leiterplatte mit einer weiteren Leiterbahnenlage zusammenlaminiert wird, tritt das Problem der Delamination am akutesten auf. Das Verfahren und das Erzeugnis daraus sind aber keineswegs beschränkt auf derartige Zwischenlagen. Vielmehr ist der Fachmann in Kenntnis der Erfindung ohne weiteres in der Lage, diese auch auf anders zusammengesetzte Schichtträger anzuwenden.

## Patentansprüche

1. Verfahren zur Herstellung einer laminierten Verbindung zwischen einer Metalloberfläche und einer Polymeroberfläche, wobei beim Laminieren Polymermaterial in vorgängig auf der Metalloberfläche erstellte Vertiefungen gepresst wird, **dadurch gekennzeichnet**, dass durch photochemische Prozessschritte auf der Metalloberfläche eine Maske erzeugt wird, dass diese Maske derart unterätzt beziehungsweise galvanisch überplattiert wird, dass in der Metalloberfläche bauchig geformte Höhlungen beziehungsweise auf der Metalloberfläche pilzförmige Erhöhungen geformt werden, und dass vor dem Auflaminieren der Polymeroberfläche die Maske entfernt wird.

2. Verfahren nach Anspruch 1, **dadurch gekennzeichnet**, dass die Metalloberfläche aus Invar oder Molybdän besteht.

3. Verfahren nach Anspruch 1 oder 2, **dadurch gekennzeichnet**, dass das Aufplattieren mit Kupfer oder Nickel erfolgt.

4. Verfahren nach Anspruch 1, **dadurch gekennzeichnet**, dass von einer Folie ausgegangen wird, deren aussenliegende Metallschicht eine auf einem Kern (4) mit geringerem Wärmeausdehnungskoeffizient aufgewalzte Kupferschicht (5) ist.

5. Verfahren nach Anspruch 4, **dadurch gekennzeichnet**, dass vor der Erstellung der Vertiefungen die Kupferschicht (5) an ihrer Oberfläche durch Aufbringen von Nickel und anschliessende Wärmediffusionsbehandlung gehärtet wird und das Ätzen der Vertiefungen über den Zeitpunkt des Durchätzens der gehärteten Schicht fortgesetzt wird.

6. Verfahren zur Herstellung einer mehrschichtigen, laminierten Leiterplatte mit Schichten (2, 3) unterschiedlicher Wärmedehnung, wobei mindestens eine innere Metallschicht (5) an ihrer Oberfläche nach dem Verfahren nach einem der Ansprüche 1 bis 5 mit Vertiefungen versehen wird, bevor die nächste Leiterbahnenlage (8, 9), die aus einer Polymerschicht und darauf aufgebrachten Leiterbahnen besteht, auflaminiert wird.

7. Mehrschichtige, laminierte Leiterplatte mit Schichten (2, 3) unterschiedlicher Wärmedehnung, mit mindestens einer inneren Metallschicht (5), auf der eine Leiterschicht (8, 9), bestehend aus einer Polymerschicht und darauf aufgebrachten Leiterlagen, auflaminiert ist, **dadurch gekennzeichnet**, dass die Metallschicht an mindestens einer ihrer Oberflächen ein Muster von bauchig geformten Höhlungen oder pilzförmigen Erhöhungen aufweist.

8. Metallfolie, insbesondere Folienkern (4, 5) aus Invar oder Molybdän für die Stabilisierung mehrlagiger Leiterplatten gemäss Anspruch 7, **dadurch gekennzeichnet**, dass die Metallfolie an mindestens einer ihrer Oberflächen ein Muster von bauchig geformten Höhlungen oder pilzförmigen Erhöhungen aufweist.

9. Metallfolie nach Anspruch 8, **dadurch gekennzeichnet**, dass die Vertiefungen ausgeätzt sind.

10. Metallfolie nach Anspruch 8, **dadurch gekennzeichnet**, dass die Vertiefungen durch aufplattierte Erhöhungen (15) gebildet sind.

11. Metallfolie nach einem der Ansprüche 8 bis 11, **dadurch gekennzeichnet**, dass sie eine äussere Schicht aus Kupfer aufweist.

12. Metallfolie nach Anspruch 11, **dadurch gekennzeichnet**, dass die Kupferschicht nickelgehärtet ist.

13. Metallfolie nach einem der Ansprüche 8 bis 12, **dadurch gekennzeichnet**, dass sie mindestens zwei Bereiche mit unterschiedlichen Mustern von Vertiefungen aufweist.

14. Metallfolie nach Anspruch 13, **dadurch gekennzeichnet**, dass eines der Gebiete kein Muster von Vertiefungen aufweist.

## Claims

1. Method for producing a laminated connection between a metal surface and a polymer surface, in which during lamination polymer material is pressed into depressions previously made on the metal surface, characterized in that by photochemical process steps a mask is produced on the metal surface, that this mask is so underetched or electroplated that in the metal surface are shaped convex cavities or on the metal surface mushroom-shaped protuberances, and that prior to laminating on the polymer surface the mask is removed.

2. Method according to claim 1, characterized in that the metal surface is of invar or molybdenum.

3. Method according to claim 1 or 2, characterized in that plating on takes place with copper or nickel.

4. Method according to claim 1, characterized in that the starting product is a foil, whose outer metal coating is a copper coating (5) rolled onto a core (4) with a lower thermal expansion coefficient.

5. Method according to claim 4, characterized in that prior to producing the depressions, the copper coating (5) undergoes surface hardening by the application of nickel and a subsequent heat diffusion treatment and the etching of the depressions is continued on beyond the time of etching through the hardened coating.

6. Method for producing a multilayer, laminated circuit board with coatings (2, 3) having different thermal expansions, at least one inner coating (5) being provided with depressions on its surface according to the method of one of the claims 1 to 5, before the next conductor layer (8, 9), which comprises a polymer coating and conductors applied thereto is laminated on.

7. Multilayer, laminated circuit board with coatings (2, 3) having different thermal expansions, with at least one inner metal coating (5) onto which is laminated a conductor coating (8, 9) comprising a polymer coating and conductor layers applied thereto, characterized in that the metal coating has on at least one of its surfaces a pattern of convex cavities or mushroom-shaped protuberances.

8. Metal foil, particularly foil core (4, 5) of invar or molybdenum for stabilizing multilayer circuit boards according to claim 7, characterized in that the metal foil has on at least one of its surfaces a pattern of convex cavities or mushroom-shaped protuberances.

9. Metal foil according to claim 8, characterized in that the depressions are etched out.

10. Metal foil according to claim 8, characterized in that the depressions are formed by plated on protuberances (15).

11. Metal foil according to one of the claims 8 to 11, characterized in that it has an outer copper coating.

12. Metal foil according to claim 11, characterized in that the copper coating is nickel-hardened.

13. Metal foil according to one of the claims 8 to 12, characterized in that it has at least two areas with different patterns of depressions.

14. Metal foil according to claim 13, characterized in that one of the areas has no pattern of depressions.

## Revendications

1. Procédé de création d'une liaison stratifiée entre une surface métallique et une surface en polymère, dans lequel le matériau polymère stratifié est pressé dans des dépressions formées au préalable à la surface du métal, caractérisé en ce que des étapes de procédé photochimiques produisent un masque à la surface du métal, en ce que ce masque est sapé par gravure ou recouvert par électroplacage de façon à former des creux concaves dans la surface du métal ou des saillies en forme de champignon sur la surface du métal, et en ce que le masque est éliminé avant l'application de la surface en polymère.

2. Procédé selon la revendication 1, caractérisé en ce que la surface métallique se compose d'Invar ou de molybdène.

3. Procédé selon la revendication 1 ou 2, caractérisé en ce que le placage est réalisé avec du cuivre ou du nickel.

4. Procédé selon la revendication 1, caractérisé en ce qu'on part d'une feuille dont la couche métallique extérieure est une couche de cuivre (5) laminée sur une âme (4) à faible coefficient de dilatation thermique.

5. Procédé selon la revendication 4, caractérisé en ce que la couche de cuivre (5) est durcie en surface par application de nickel puis traitement thermique de diffusion avant la réalisation des dépressions, et la gravure des dépressions se poursuit au-delà du moment où la couche durcie est traversée.

6. Procédé pour la réalisation d'une plaque de circuits imprimés stratifiée multicouches avec des couches (2, 3) à dilatation thermique différente, une couche métallique intérieure (5) au moins étant pourvue de dépressions à la surface, selon le procédé selon l'une ou l'ensemble des revendications 1 à 5, avant que la couche de pistes conductrices (8, 9) suivante, qui se compose d'une couche de polymère et de pistes conductrices formées sur celle-ci, soit laminée par-dessus.

7. Plaque de circuits imprimés stratifiée multicouches pourvue de couches (2,3) de dilatation thermique différente, avec au moins une couche métallique intérieure (5) sur laquelle est laminée une couche conductrice (8, 9) composée d'une couche de polymère et de couches conductrices appliquées sur celle-ci, caractérisée en ce que la couche métallique présente sur au moins l'une de ses surfaces un motif de dépressions concaves ou de saillies en forme de champignon.

8. Feuille métallique, en particulier âme en feuille (4, 5) en Invar ou en molybdène pour la stabilisation de plaques de circuits imprimés multicouches selon la revendication 7, caractérisée en ce que la couche métallique présente sur l'une au moins de ses surfaces un motif de dépressions concaves ou de saillies en forme de champignon.

9. Feuille métallique selon la revendication 8, caractérisée en ce que les dépressions sont formées par gravure.

10. Feuille métallique selon la revendication 8, caractérisée en ce que les dépressions sont formées par des saillies (15) plaquées par-dessus.

11. Feuille métallique selon l'une ou l'ensemble des revendications 8 à 11, caractérisée en ce qu'elle présente une couche extérieure en cuivre.

12. Feuille métallique selon la revendication 11, caractérisée en ce que la couche de cuivre est durcie au nickel.

13. Feuille métallique selon l'une ou l'ensemble des revendications 8 à 12, caractérisée en ce qu'elle présente au moins deux zones où les motifs de dépressions sont différents.

14. Feuille métallique selon la revendication 13, caractérisée en ce que l'une de ces zones ne présente pas de motif de dépressions.
